# EUROPEAN PATENT APPLICATION

(11) **EP 4 738 627 A1**
(43) Date of publication of application: **06.05.2026**
(21) Application number: 25207916.5
(22) Date of filing: 10.10.2025
(51) Int. Cl.: H01S 5/0687, H01S 5/40, H01S 5/00, H01S 5/12, H01S 5/14, H01S 5/323, G01N 21/25, G01N 21/39

(54) **OFFSET LOCKED DUAL LASER SYSTEM FOR MTS SPECTROSCOPY**

(30) Priority: 01.11.2024 US 202418935036
(71) Applicant: Vector Atomic, Inc., Pleasanton, CA 94566 (US)
(72) Inventor: CINGOZ, Arman, Pleasanton, CA, 94566 (US); BOYD, Martin Machai, Pleasanton, CA, 94566 (US); KOWLIGY, Abijith Sudarsan, Pleasanton, CA, 94566 (US); ROSLUND, Jonathan David, Pleasanton, CA, 94566 (US)
(74) Representative: Kehl, Ascherl, Liebhoff & Ettmayr Patentanwälte Partnerschaft mbB

(57) **Abstract**

Embodiments herein describe photonic systems with two laser sources that are tasked with generating the pump and probe optical signals for MTS spectroscopy. However, instead of having the same frequency, a control system can introduce a frequency offset which can be used to filter out interference between the optical signals that can occur before they pass through a vapor cell. In one embodiment, the optical signals are combined and detected at a photodiode that generates a beatnote that can be used to ensure the frequency offset is maintained.

## Description

### BACKGROUND

### Field

Embodiments of the present invention generally relate to photonic systems to perform spectroscopy.

### Description of the Related Art

Optical atomic clocks offer improved frequency instabilities compared to microwave frequency standards due to the higher quality factor Q associated with an optical resonance. In order to take advantage of these high quality factors, a coherent interaction between the light and matter is required. One barrier to the widespread deployment of optical frequency standards is the requirement to develop compact, robust, and low-power laser sources amenable to integration at the optical frequency of interest. Additionally, the photonic system must offer a means for controlling the systematic errors typically associated with optical frequency standards, including residual amplitude modulation (RAM) and AC-light shifts.

In order to eliminate first-order Doppler effects associated with interrogating a warm atomic vapor, the photonic systems typically employ modulation transfer spectroscopy (MTS) or frequency modulation spectroscopy (FMS). However, these approaches often rely on multiple expensive and power-hungry optical components such as acousto-optic modulators (AOM) and Electro-optic modulators (EOMs). For example, previously demonstrated MTS techniques start with two distinct optical beams, pump and probe signals, where each of these beams passes through its own AOM. The pump beam AOM creates both a static frequency offset from the probe and imparts a modulation. Often the photonic system requires frequency doubling to reach the sample wavelength, which adds complexity to the generation of the pump and probe beams with appropriate characteristics. Each of the beams may pass through a respective second harmonic generation (SHG) module to change the wavelength of the signals. MTS spectroscopy is performed with the two resultant beams. However, providing discrete AOMs and SHG modules in both optical paths adds substantial cost to the system, bulk, and power consumption.

Generation of the two spectroscopy beams with appropriate characteristics for MTS is challenging in a simple photonic system due to requirements that the probe beam have no spurious modulation present from the pump light or control electronics. In addition, reliable reduction of RAM in the pump beam is complicated by polarization properties of modulators. Fiber delivery of the beams to the atomic setup is ideal in many cases, however fiber exacerbates potential for undesired modulated light on the probe beam path through etalons, and improper control of RAM through polarization variation over temperature and time in the fibers.

### SUMMARY

One embodiment described herein is a photonic system that includes a first laser source configured to generate a pump optical signal for modulation transfer spectroscopy (MTS), a second laser source configured to generate a probe optical signal for MTS, an optical combiner configured to optically combine a portion of the pump and probe optical signals to generate a combined optical signal, a photodiode configured to receive the combined optical signal and output a beatnote, and a control system configured to, based on receiving the beatnote, adjust a parameter of at least one of the first or second laser sources to set a desired frequency offset between the pump and probe optical signals.

One embodiment described herein is a PIC that includes waveguides configured to direct a first portion of a pump optical signal to a vapor cell for MTS, combine a second portion of the pump optical signal with a first portion of a probe optical signal to generate a combined optical signal, direct the combined optical signal to a photodiode configured to output a beatnote for maintaining a frequency offset between the pump and probe optical signals, and direct a second portion of the probe optical signal to the vapor cell for MTS.

One embodiment described herein is a method that includes receiving two laser signals from two separate laser sources, generating a beatnote between the two laser signals using a photodiode, setting a desired frequency offset between the two laser signals based on the beatnote, modulating one of the two laser signals to generate a pump optical signal, wherein the other of the two laser signals is unmodulated to generate a probe optical signal, and transmitting the pump optical signal and the probe optical signal to a vapor cell to perform modulation transfer spectroscopy (MTS).

### BRIEF DESCRIPTION OF THE DRAWINGS

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings illustrate only exemplary embodiments and are therefore not to be considered limiting of its scope, may admit to other equally effective embodiments.
Figures 1A-1C illustrate photonic systems for performing spectroscopy, according to embodiments herein.
Figures 2A and 2B illustrate photonic systems for performing spectroscopy, according to embodiments herein.
Figures 3-6 illustrates photonic systems for performing spectroscopy, according to embodiments herein.
Figure 7 is a flowchart for performing MTS, according to one embodiment.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION

Embodiments herein describe photonic systems that provide frequency, amplitude, and power-stabilized light without using an acoustic-optic modulator (AOM). The photonic system is adaptable to MTS spectroscopy schemes. The photonic systems include two optical sources that are tasked with generating the pump and probe optical signals for MTS spectroscopy. However, instead of having the same frequency, a control system can introduce a frequency offset (e.g., an offset of 100-200 MHz). A frequency offset between the pump and probe optical signals is desirable in MTS spectroscopy in order to avoid spurious interference effects between the beams that can mimic spectroscopy signals and cause systematic frequency offsets in the laser locks. In one embodiment, the optical signals are combined and detected at a photodiode that generates a beatnote that can be used to ensure the offset frequency is maintained.

In addition, the laser source generating the pump signal can be modulated, either at the laser source or downstream by an optical modulator (e.g., a phase modulator). Moreover, the amplitudes (e.g., power or intensity) of the optical signals can be controlled using amplitude control modules in both the probe and pump optical paths. These optical signals can then be transmitted to a vapor cell (also referred to as a gas cell) to perform spectroscopy. While two laser sources are used (rather than one as is in the case in a typical MTS system) advantageously, such a photonic system can generate the pump and probe optical signals without any AOM, thereby reducing costs and space in the photonic system relative to previous solutions. Moreover, the complexity of using two laser sources can be mitigated by using a photonic integrated circuit (PIC). That is, the amplitude control modules, the photodiode, waveguides, resonators, splitters, optical modulates, etc. can be integrated onto a PIC, which can be easily aligned with (e.g., butt coupled to) the laser sources.

In addition, some of the components in the spectroscopy system may be better suited for different photonic platforms. For example, while resonators and amplitude control modules may be easily implemented in a silicon nitride PIC, other components such as optical modulators (e.g., phase modulators) and frequency doublers may use second order non-linearity materials such as lithium niobate. In that case, a hybrid approach can be used where a first PIC (e.g., silicon nitride) is bonded or attached to a second PIC (e.g., lithium niobate) where the PICs share optical signals. In a heterogeneous approach, a second order non-linearity material can be added to a silicon nitride PIC (e.g., using transfer printing) so there is one PIC that can implement the various components.

However, the two-laser MTS system described herein is not limited to using PIC(s) and can be implemented using discrete optical components that are connected by fiber or free space optics. Nonetheless, using one or more PICs can result in reduced cost and enable mass production (since discrete components take up more space and generally cost more than their integrated counterparts). Moreover, on-chip lasers can have narrower linewidth in a smaller form factor. Also, the PIC(s) can perform other functions besides MTS such as having components for stabilizing a frequency comb.

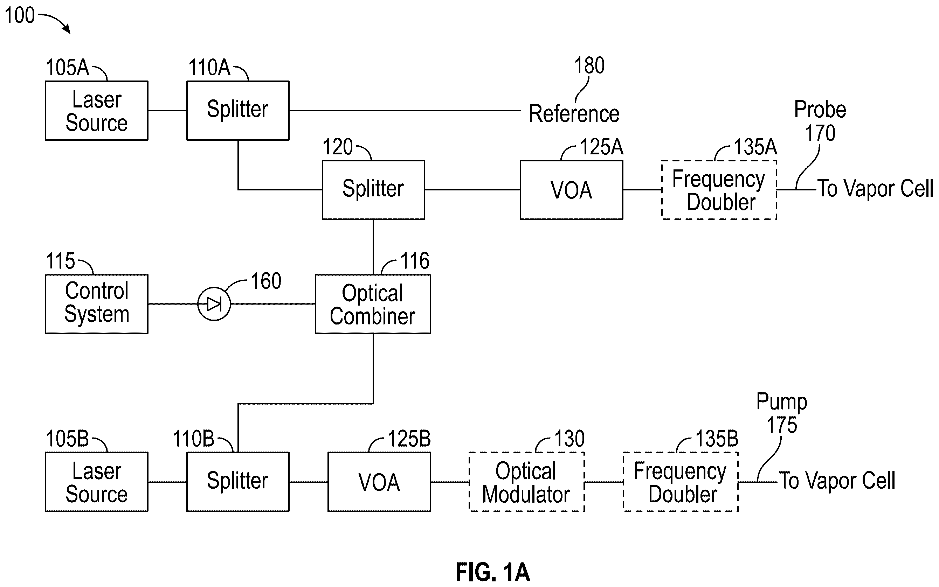

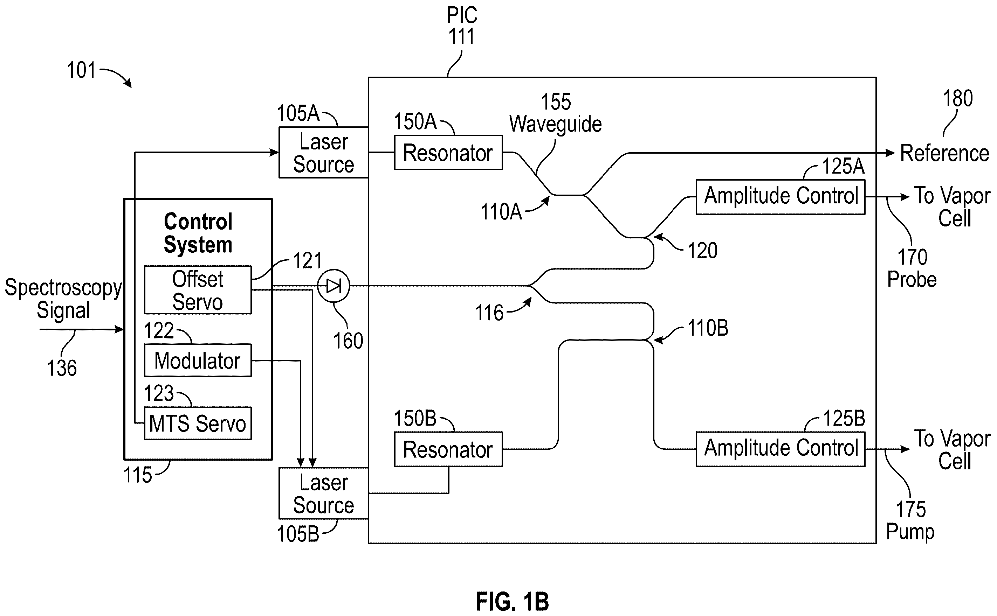

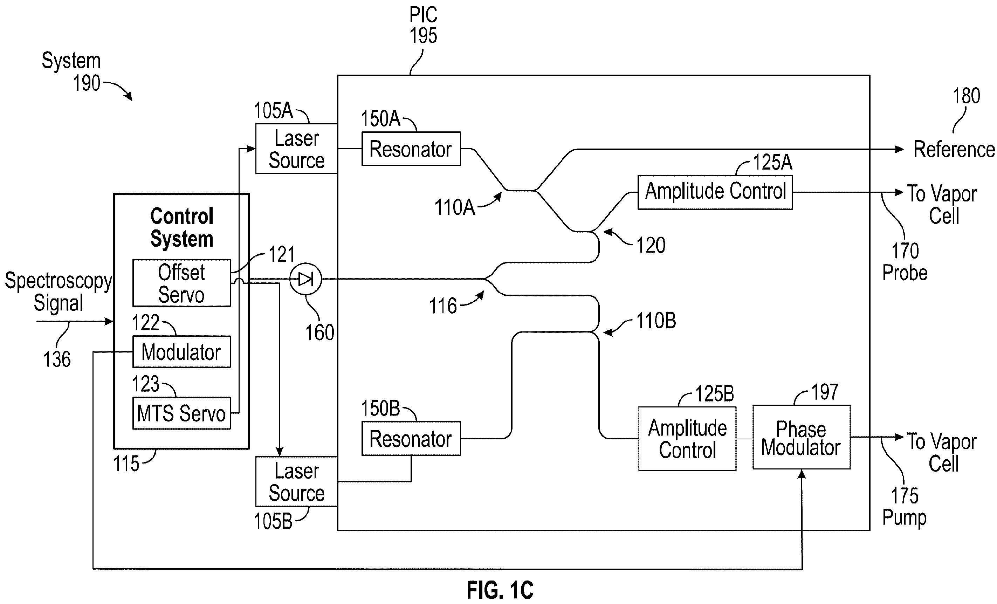

Figures 1A-1C illustrate photonic systems for performing spectroscopy, according to embodiments herein. Figure 1A illustrates a photonic system 100 for performing spectroscopy, according to one embodiment. The photonic system 100 uses two lasers to perform MTS. In one embodiment, the system 100 uses discrete optical components where the lines can represent either optical fibers or free space optical paths between the discrete components. However, in another embodiment, some of the components are implemented using a PIC. This is discussed in Figures 1B and 1C.

The system 100 includes two laser sources 105A and 105B. These laser sources 105 can output optical signals that are the same wavelength as the absorption peak of the vapor cell (e.g., 520 nm in the case of iodine vapor cell) or at a different convenient wavelength that can be converted to the desired wavelength using standard wavelength conversion techniques. For example, if the lasers output optical signals at twice the desired wavelength (e.g., 1064 nm for the case of iodine) then the frequency doublers 135A and 135B can be added. Thus, these components are optional depending on the selection of the laser sources 105, as indicated by the dotted lines and may be replaced with other components such as frequency triplers depending on the laser emission and desired absorption wavelengths.

The system 100 includes a control system 115 which can in turn include the offset servo, modulator, and MTS servo which are discussed in more detail in the figures below. In one embodiment, the control system 115 modulates (e.g., dithers/sweeps) the laser source 105B directly. However, in another embodiment, the system 100 can include a discrete optical modulator 130 for performing the modulation for MTS. Thus, the optical modulator 130 (e.g., an EOM) is optional depending on whether the laser source 105 is modulated or not, as indicated by the dotted line.

The outputs of the laser sources 105 are received at respective splitters 110A and 110B. One output of the splitter 110A is received at a splitter 120 while the other output is used as a reference signal 180. In turn, one output of the splitter 120 is received (and combined) at an optical combiner 116 with one of the outputs of the splitter 110B. The output of the optical combiner 116 is transmitted to a photodiode or photodetector (PD) 160 to generate a beatnote for maintaining a frequency offset.

The other output of the splitter 120 is received at a first optical amplitude controller 125A.

The other output of the splitter 110B is received at a second optical amplitude controller 125B. The optical amplitude controllers 125 can be implemented using VOAs, AOMs, liquid lenses, and the like. The optical amplitude controllers 125 can perform a similar function as the amplitude controls 165 discussed in the figures below.

After passing through the optional optical modulator 130 and frequency doublers 135, probe 170 and pump 175 optical signals are transmitted to a vapor cell. While using one or more PICs (as shown in Figures 1B, 1C, 2A, 2B, 3, 4, 5, and 6) may reduce cost and space relative implementing the photonic system 100 using discrete components, Figure 1 illustrates that a two-laser MTS system with a frequency offset can be realized using discrete components or using one or more PICs.

Figure 1B illustrates a photonic system 101 with many of the same components as shown and described in Figure 1A. The same components are given the same reference numbers as used in Figure 1A. Figure 1B illustrates a photonic system 101 that includes a PIC 111, laser sources 105A and 105B, and the control system 115. In this embodiment, it is assumed the laser sources 105 lase at a frequency that is close to an absorption peak of the gas in the vapor cell that receives the probe 170 and pump 175 optical signals. As an example, InGaN lasers lase at around 515-520 nm which corresponds to an absorption peak of an iodine vapor cell where light is absorbed (so the iodine gas fluoresces). For example, the laser sources 105 can be a 520 nm Fabry-Perot (FP) laser source.

The laser sources 105 can also be hybrid implementation where the gain regions of the laser sources 105 are on separate gain chips that are bonded or attached to the PIC 111. However, in other embodiments, the laser sources 105 may be integrated into the PIC 111. Moreover, as discussed in more detail below, some portions of the laser sources may be implemented in separate chips (e.g., the gain chip) while other portions of the laser sources (e.g., the resonators 150) are in the PIC 111. These hybrid structures allow implementation of tunable Vernier lasers, self-injection lasers, or Stimulated Brillouin Scattering (SBS) lasers, which typically have much narrower linewidths than discrete lasers, allowing for more precise determination of spectroscopic features or better performance when lasers are locked to the vapor cell signals.

The control system 115 can be implemented by hardware, software, or a combination thereof. In one embodiment, the control system 115 is a field programmable gate array (FPGA) or an application specific integrated circuit (ASIC) with circuitry that performs the functions herein. In other embodiments, the control system 115 can be implemented using software executing on a computing system (e.g., a processor).

The control system 115 includes an offset servo 121, a modulator 122, and a MTS servo 123. The offset servo 121 includes circuitry or software functions that set the offset between the laser sources 105. In previous MTS implementations, this frequency offset was accomplished using an AOM. However, here, the frequency offset can be maintained by using a photodiode 160 to generate a beatnote. The offset servo 121 receives the beatnote (an electrical signal) and generates an output signal that controls a parameter of the laser source 105B to change its frequency so the desired frequency offset (e.g., 100-200 MHz) is maintained between the frequencies of the laser sources 105A and 105B. In one embodiment, the offset servo 121 phase locks the beatnote to a radio frequency (RF) oscillator in the control system 115 (e.g. circuitry of a software function).

The modulator 122 (e.g., circuitry or a software function) adds a dither or modulation to the laser source 105B that is used to perform MTS in the range of 50 - 300 kHz. That is, the modulator 122 frequency modulates the laser source 105B to dither its output frequency. The spectroscopy signal 136 can be generated as result of passing the probe 170 and pump 175 optical signals through the vapor cell. For example, the spectroscopy signal 136 can be an absorption signal received from the spectrometer (at the modulation frequency). The embodiments herein are not limited to any particular set up or bench for the vapor cell, and any arrangement can be used that generates a suitable spectroscopy signal 136 for locking the laser source 105A to the absorption peak.

The MTS servo 123 (e.g., circuitry or a software function) uses the spectroscopy signal 136 to generate a control signal for the laser source 105A. The MTS servo 123 demodulates the absorption signal to create an error signal and adjusts the frequency of the laser source 105A to keep it on resonance so that it matches the frequency of the absorption peak of the vapor cell, to a very high precision. Since laser source 105B is locked to laser source 105A by the offset servo 121, both laser sources 105 can be set to precise frequencies (with the user defined frequency offset).

By synchronizing the laser sources 105 with a well-defined frequency offset, the system 101 can remove unwanted signals from reflections in the spectroscopy bench where some of the modulated light from the pump 175 can interfere with the probe 170, before (or after) the signals have passed through the vapor cell (where they are intended to interact when their frequencies are at an absorption peak of the gas in the vapor cell). If there is any mixing/interaction between the probe 170 and pump 175 optical signals on the photodiode that generates the spectroscopy signal 136, this leads to a signal in the 100-200 MHz range of the frequency offset, as opposed to the modulation frequency generated by the modulator 122, which can be ignored by the control system 115 using a low pass filter. In this manner, maintaining the frequency offset enables the control system 115 to reject unintended signals arising from mixing of the pump and the probe without interacting within the vapor cell.

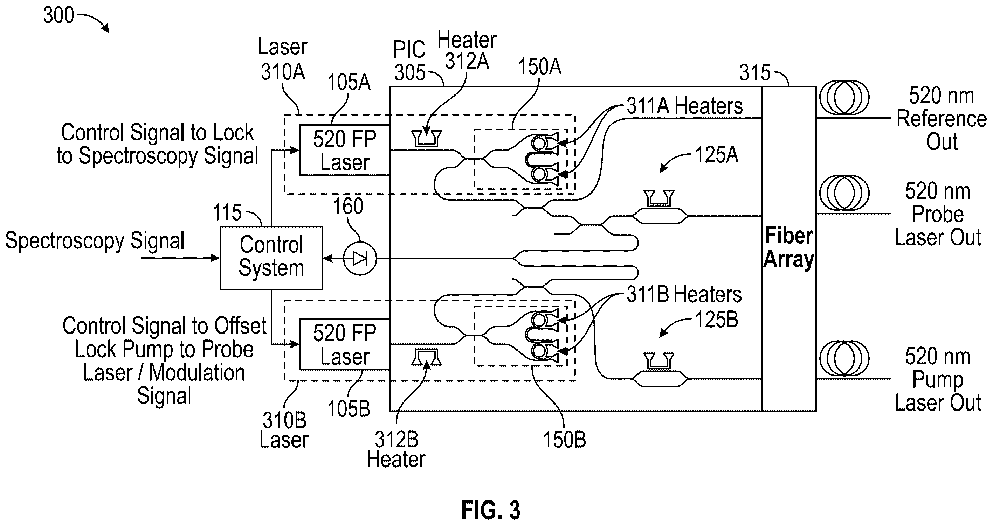

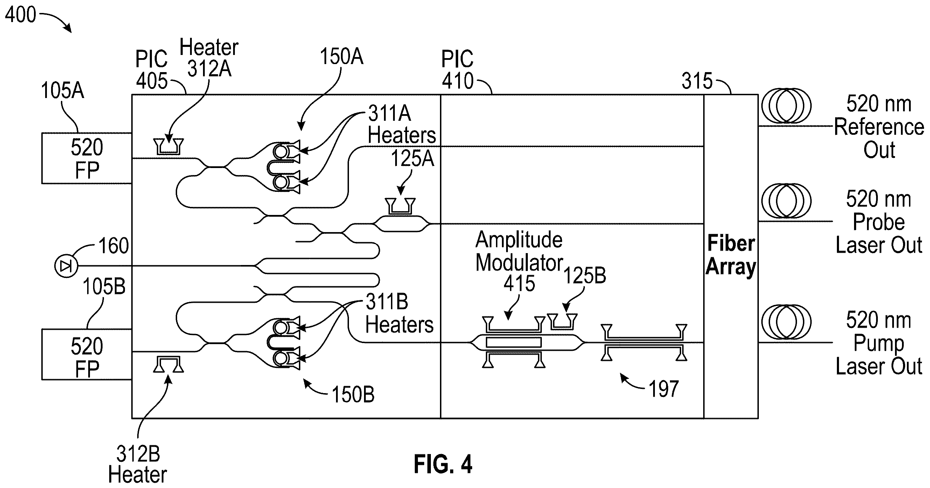

As shown, the PIC 111 includes resonators 150, the photodiode (PD) 160, amplitude controls 125, the splitters 110A, 110B, 120, and the optical combiner 116. The resonators 150 are optional structures on the PIC that can be used to narrow the emission frequency band of laser sources 105A and 105B. For example, typical wavelengths utilized for iodine MTS spectroscopy lie in the 515-520 nm wavelength range where semiconductor lasers based on indium gallium nitride (InGaN) are commercially available but are multi-mode Fabry Perot (FP) lasers with a broad spectrum that covers the entire range. To be used for high resolution MTS spectroscopy, the lasers can be forced to lase at a single longitudinal mode by optical feedback from resonators 150 on the PIC 111 at a user desired frequency. For example, resonators 150 can be a single ring resonator or a coupled ring structure that provides an effective free-spectral range larger than the gain bandwidth of the laser gain medium. Details of a typical structure for resonators 150 are provided in Figures 3 and 4.

The resonators 150 can be considered as part of the laser source 105. That is, the combination of the laser source 105 (which can be external to, or mounted to/on, the PIC 111) and the resonator 150 can be considered as a laser.

The PIC 111 includes various waveguides 155 to transmit optical signals to different optical components in the PIC 111. In this case, the output of the resonator 150A is split by the waveguides 155 using the splitter 110A where a first portion is used as a reference signal 180 for, e.g., stabilizing a frequency comb. The second portion is again split by the waveguides 155 using splitter 120 and transmitted to the optical combiner 116 and the amplitude control 125A. The amplitude controls 125A and 125B can stabilize the amplitudes of the probe 170 and pump 175 signals. Implementation details of the amplitude controls 125A and 125B are provided in Figures 3 and 4.

The output of the resonator 150B is split by the waveguides 155 using splitter 110B such that a portion is combined with the output of the resonator 150A and then combined with a portion of the output of the resonator 150A at the optical combiner 116. The remaining portion is transmitted to the amplitude control 125B and then is used as the pump optical signal 175. In this example, the splitters 110A, 110B, 120, and the optical combiner 116 can be implemented using waveguides 155 in the PIC 111. In one embodiment, the split ratio of the splitters 120 and 110B are set so that a small portion of the optical signal is transmitted to the combiner 116 and to the PD 160 (e.g., 1-5% of the total output of the splitters).

The output of the optical combiner 116 is provided to the PD 160, which is a beatnote detector that generates an electrical signal for the offset servo 121 as discussed above. The PD 160 is shown as being external to the PIC 111 (e.g., mounted onto the PIC 11), but in other embodiments could be transfer printed onto the PIC 111 so it is integrated into the PIC 111.

The PIC 111 can be made from any number of materials, such as SiN, aluminum nitride, tantalum pentoxide, LiNbO3, etc. Further, the optical signals on the right of the PIC 111 can be coupled into a fiber array, or could use free space optics to be transmitted to downstream optical components, like the vapor cell.

Figure 1C illustrates a photonic system 190 with many of the same components as shown and described in Figures 1A and 1B. The same components are given the same reference numbers as used in Figures 1A and 1B. However, the difference between Figures 1B and 1C is that in Figure 1C the PIC 195 includes a phase modulator 197 for modulating (e.g., dithering) the pump optical signal, rather than the laser source 105B modulating the pump 175. As such, in Figure 1C the laser source 105B outputs a unmodulated optical signal, like the laser source 105A does in both Figures 1B and 1C.

Instead of being connected to the laser source 105B, the modulator 122 controls the phase modulator 197 (e.g., an EOM) in order to modulate the pump 175. Because the modulation is performed by the phase modulator 197, this means an unmodulated pump signal is received at the PD 160 by the optical combiner 116. That is, in contrast to Figure 1B where the PD 160 compares the unmodulated probe with the modulated pump, in Figure 1C, the PD 160 compares two unmodulated optical signals. Comparing unmodulated signals may be desirable in order generate an offset frequency beatnote that is not contaminated by the modulation introduced by the modulator 122. This allows for a cleaner error signal that can result in a higher lock bandwidth for the offset servo 121.

While using a phase modulator 197 can result in higher quality offset locking using the PD 160 and the offset servo 121, the phase modulator 197 may be made from special materials (e.g., a second order non-linear material) which may be different from the material used to form the other optical components in the PIC 195. While in one embodiment a second order non-linear material can be used to implement every component in the PIC 195, it may be advantageous to implement the phase modulator 197 on a separate PIC or to add a layer of a second order non-linear material to the PIC 195. This will be discussed in more detail in Figure 4.

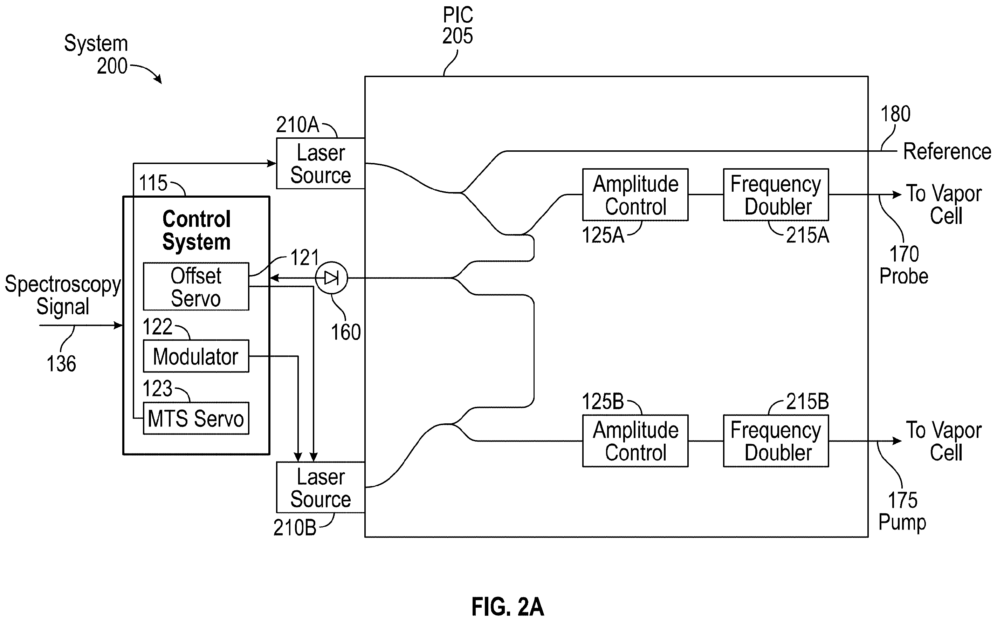

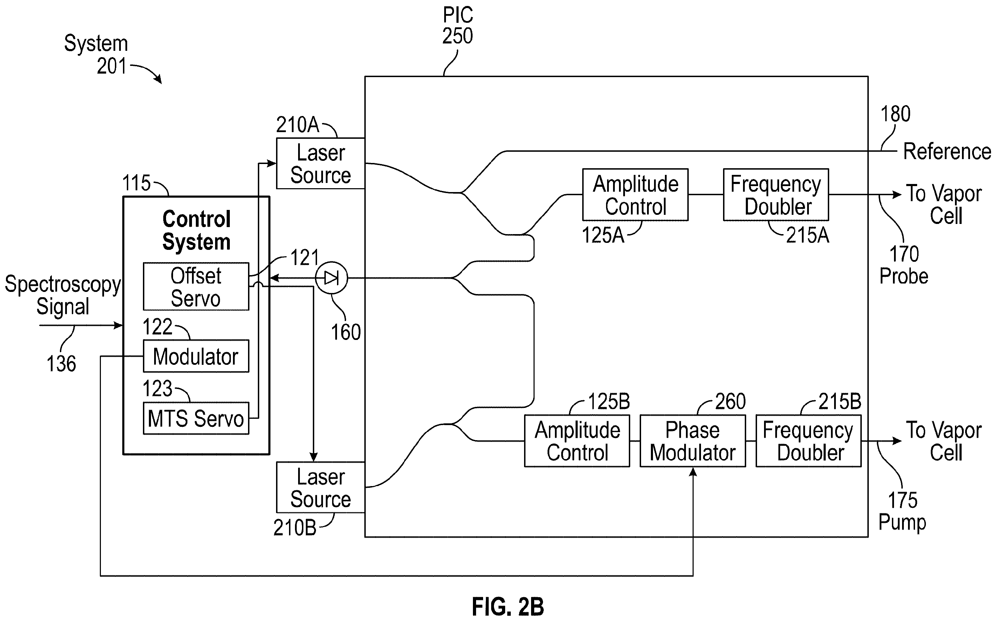

Figures 2A and 2B illustrate photonic systems for performing spectroscopy, according to embodiments herein. Figure 2A illustrates a photonic system 200 that includes a PIC 205, laser sources 210A and 210B, and the control system 115. In this embodiment, it is assumed the laser sources 210 lase at a frequency that is different from the absorption peak of the gas in the vapor cell that receives the probe 170 and pump 175 optical signals. As an example, there are many commercial laser that lase at around 1064 nm which is roughly half the frequency of an absorption peak of an iodine vapor cell. An advantage of using a 1064nm laser is there are many commercially available lasers at that wavelength which cost less and produce better laser signals (e.g., narrower linewidths and a single frequency) than 515-520 nm lasers. For example, the laser sources 210 can be 1064 nm distributed feedback (DFB) laser sources.

Despite these differences, Figures 2A and 2B include many of the same components as described in Figures 1A-1C as indicated by having the same reference numbers. Specifically, the control system 115 in Figures 2A and 2B can be the same as the control system 115 in Figures 1B and 1C, and thus, is not described in detail here. Moreover, the PIC 205 does not include the resonators since the laser sources 210 can lase at a single frequency. However, it still may be advantageous to have the resonators in the PIC 205 to help further narrow the linewidths of the laser sources 210.

While the PIC 205 includes the amplitude controls 125A and 125B (which can perform a same function as described in Figures 1A-1C), the PIC 205 also includes frequency doublers 215A and 215B. The frequency doublers 215 double the frequency (halve the wavelength) of the optical signals generated by the laser sources 210 so they are wavelengths near the absorption peak of the gas in the vapor cell. Discrete frequency doublers are very expensive, but here, they can be implemented on a PIC 205 which substantially reduces their cost as well as the space required (i.e., reduces the form factor). In addition, PIC doubler implementations are generally more broadband which allows for wavelength flexibility.

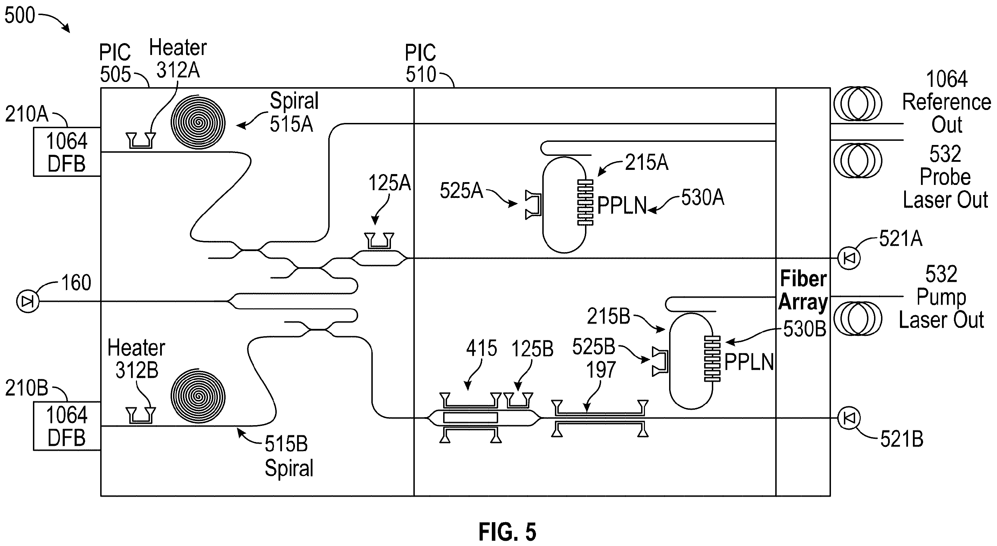

While implementing the frequency doublers 215 on a PIC reduces costs and space, the frequency doublers 215 may be made from special materials (e.g., a second order non-linear material) which may be different from the material used to form the other optical components in the PIC 205. While in one embodiment a second order non-linear material can be used to implement every component in the PIC 205, it may be advantageous to implement the frequency doublers 215 on a separate PIC or to add a layer of the second order non-linear material to the PIC 205. This is discussed in Figure 5.

In Figure 2A, the modulator 122 in the control system 115 generates a control signal for changing a parameter of the laser source 210B so it modulates (e.g., dithers or sweeps) the pump optical signal. However, as discussed above, this modulation is seen by the PD 160 when comparing the unmodulated probe with the modulated pump. This can introduce noise into the control system.

Figure 2B, in contrast, includes a photonic system 201 with a PIC 250 that includes a phase modulator 260. In this embodiment, the modulator 122 in the control system 115 generates a control signal for the phase modulator 260 so it modulates or dithers the pump 175. As such, in Figure 2B the laser source 210B outputs a CW (unmodulated) optical signal, like the laser source 210A does in both Figures 2A and 2B.

Because the modulation is performed by the phase modulator 260, this means an unmodulated pump signal is received at the PD 160. The PD 160 compares two unmodulated optical signals which may improve the offset servo 121 relative to the system in Figure 2A.

While using a phase modulator 260 can result in higher quality offset locking using the PD 160 and the offset servo 121, the phase modulator 260 (like the frequency doublers 215) may be made from a second order non-linear material which may be different from the material used to form the other optical components in the PIC 250. Thus, the phase modulator 260 and the frequency doublers 215 may be implemented on a different PIC, or the PIC 250 can include a layer of a second order non-linear material to implement these components. This is discussed in Figure 5.

Figure 3 illustrates a photonic system 300 for performing spectroscopy, according to embodiments herein. Generally, the photonic system 300 includes a PIC 305 that illustrates one exemplary implementation of the PIC 111 in Figure 1B. That is, the PIC 305 illustrates exemplary optical structures for implementing the resonators 150 and amplitude controls 125 illustrated in Figure 1B.

Figure 3 also illustrates a control system 115 (where the internal control modules are not shown). The control system 115 can perform the same function as described in Figure 1B where it generates a control signal to lock the laser source 105A (shown here as a 520 nm FP laser source) to the spectroscopy signal and uses the output of the PD 160 to generate a control signal to the laser source 105B (shown here as a 520 nm FP laser source) to offset the pump and probe optical signals by the desired frequency offset. In addition, the control system 115 provides a modulation signal to the laser source 105B to modulate/dither/sweep the pump optical signal.

As mentioned above, 520nm FP lasers sources 105 can be multi-mode (output multiple frequencies), which is undesired for MTS. The resonators 150 interact with certain frequencies of light but not others. This permits the resonators 150 to serve as optical filters so that the output of the resonators 150 is a single (desired) frequency. In Figure 3, the resonators 150 each include two ring resonators arranged as a Vernier filter. The light generated by the laser source 105 passes through both ring resonators which inject a specific frequency back towards the laser source 105 (while filtering or rejecting light at other frequencies). In one embodiment, the ring resonator diameters are specifically chosen such that the composite structure transmits only one frequency within the entire lasing band of the laser source 105 back towards the laser source 105. This causes the output to be at a single frequency (e.g., the desired frequency that corresponds to an absorption peak of the vapor cell).

Moreover, the PIC 305 includes a heater 311 disposed at a waveguide between the laser source 105 and the ring resonators. The heaters 311A and 311B heat up the waveguide to generate an optical phase shift to control the length of the ring resonators thereby changing the frequency of light they interact with (and the frequency of light they do not interact with). This gives the system 300 the ability to tune the resonators 150 as environmental conditions, such as temperature, changes. Moreover, the PIC 305 includes additional heaters 312A and 312B that adjust the phase of the optical feedback such that it is able to enter back into the FP lasers to force them to lase single frequency.

Notably, the system 300 illustrates lasers 310A and 310B that include components that are in the PIC 305 and components not integrated into the PIC 305. That is, the laser 310A includes the laser source 105A, which can be a separate gain chip, and the heater 311A and resonator 150A which are integrated in the PIC 305. However, in other embodiments, the entire laser 310 can be implemented in the PIC 305. For example, the laser source 105 may require special materials, which can be deposited on (e.g., transfer printed) onto the PIC 305 (assuming it is made from different materials). In this example, the various components of the lasers 310 are used to implement a tunable Vernier laser, but in other embodiments a self-injection laser, or SBS laser could be implemented.

In PIC 305, the amplitude controls 125A and 125B are implemented using Mach-Zehnder interferometers (MZI) with thermo-optic heaters as phase shifters in one arm. The amplitude or intensity of the pump and probe optical signals can be controlled by the phase shift introduced by the upper and lower arms. The phase shift determines the amount the signals in the upper and lower arms interfere when recombined at the output of the MZI. Thus, in this manner, on-chip MZIs can be used to replace discrete Variable Optical Attenuators (VOAs) that are typically used in spectroscopy systems, which can reduce both cost and space.

The PIC 305 can be formed using SiN, aluminum nitride, tantalum pentoxide, LiNbO3, and the like.

Figure 3 also illustrates a fiber array 315 optically coupled to the PIC 305. The fiber array permits optical fibers to be aligned with waveguides in the PIC 305 (e.g., the waveguides transmitting the reference signal, the probe, and the pump. Optical fibers can then be used to transmit these signals to downstream optical components. However, in other embodiments, the fiber array 315 can be omitted and the optical signals can be transmitted using free space optical components.

Figure 4 illustrates a photonic system 400 for performing spectroscopy, according to embodiments herein. Generally, the photonic system 400 includes a PIC 405 and a PIC 410 that illustrates one exemplary implementation of the optical components in Figure 1C. Rather than implementing these optical components in a single PIC as shown in Figure 1C, in Figure 4 the PIC 405 includes the heaters 311, heaters 312, the resonators 150, and the amplitude control 125A while the PIC 410 includes the amplitude control 125B, the phase modulator 197, and an amplitude modulator 415.

In one embodiment, the PIC 405 and the PIC 410 include different materials for forming their respective optical components. For example, the PIC 405 can be SiN while the PIC 410 is LiNbO₃ (e.g., a second order non-linear material). The two PICs 405 can be aligned so that the output waveguides of the PIC 405 align with input waveguides in the PIC 410. For example, the two PICs 405 can be butt coupled using respective sides. In another embodiment, the two PICs could be disposed on top of each other (e.g., wafer bonded) and are optically coupled in the vertical direction.

As mentioned when discussing Figure 1C, all the components shown in Figure 4 can be in a single PIC. For example, the PIC could be a SiN wafer where transfer printing is used to add a layer of LiNbO₃ at locations of the PIC that include the optical components that use a second order non-linear material, e.g., the electro-optic phase modulator 197 and the amplitude modulator 415. Similarly, the PIC could be made from LiNbO₃ which would allow for all the functionality on a single chip.

In both PICs 405 and 410, the amplitude controls 125A and 125B are implemented using MZIs. However, the amplitude control 125B is in the PIC 410 while the amplitude control 125A is in the PIC 405. This is optional since the amplitude control 125B can be implemented in the PIC 405 and conversely the amplitude control 125A could be implemented in the PIC 410. Since the PIC 410 includes the amplitude modulator 415, it may reduce cost to extend the upper and lower arms to implement the amplitude control 125B as shown as part of the same MZI structure. That is, the amplitude modulator 415 can be implemented on a first part of the MZI structure while the amplitude control 125B is implemented on a second part of the same MZI structure.

In one embodiment, the amplitude modulator 415 is a push-pull amplitude modulator constructed using a MZI with an electro-optic phase modulator in each arm. By using this structure, the amplitude modulator can attain the same bandwidth as the phase modulator 197 and therefore used to cancel out residual amplitude modulation created by the phase modulator 197. In contrast, the amplitude control 125B can be a slower thermo-optic modulator used to control the overall amplitude of the optical signal.

The electro-optic effect in non-centrosymmetric materials such as lithium niobate or aluminum nitride is used to implement phase, or amplitude, modulators. In lithium niobate, the largest electro-optic coefficient (r₃₃ ~ 30 pm/V) is along the extraordinary axis in its crystal structure (c-axis) so x-cut thin film lithium niobate (TFLN) is commonly used in PICs. This ensures that the low-loss transverse electric polarized mode will see the largest EO effect. For micro-transfer printing, typically a 200-300 nm thick x-cut TFLN wafer is placed on the SiN (or similar) platform. Radio-frequency guiding transmission lines or electrodes are deposited on the TFLN around the waveguides in ground-signal-ground or similar configurations to provide phase-modulation or in a MZI configuration, amplitude modulation. Aluminum nitride is more amenable to conventional PIC fabrication and is typically deposited via LPCVD or PECVD and randomizes its crystalline orientation, resulting in a lower EO coefficient (~1 pm/V).

The PICs 405 and 410 can be formed using SiN, aluminum nitride, tantalum pentoxide, LiNbO3, and the like. In general, the PICs 405 and 410 can be formed from any two different materials that can implement the optical components described above.

Figure 5 illustrates a photonic system 500 for performing spectroscopy, according to embodiments herein. Generally, the photonic system 500 includes a PIC 505 and a PIC 510 that illustrates one exemplary implementation of the optical components in Figure 2B. Rather than implementing these optical components in a single PIC as shown in Figure 2B, in Figure 5 the PIC 505 includes the heaters 311, the resonators 150, and the amplitude control 125A while the PIC 510 includes the amplitude control 125B, the phase modulator 197, the amplitude modulator 415, and the frequency doublers 215.

The PIC 505 includes spiral resonator 515A and 515B, which are one implementation of resonators 150. In this implementation they can be used to narrow the linewidth of lasers sources 210A and 210B by injecting some of the light back towards the laser sources 210. However, these features are optional if the laser sources 210 generate an optical signal with low noise and a sufficiently narrow linewidth.

Also, the PIC 510 includes PDs 521A and 521B which can be used to monitor the light coupled into the frequency doublers 215 (and are shown as being off the PIC 510, but could be transfer printed onto/into the PIC 510). In this example, the frequency doublers 215 are based on periodically poled lithium niobate (PPLN) 530 placed inside a ring resonator. The ring resonators increase the intensity of the optical signals that propagate through the PPLNs 530A and 530B which double the frequency of the light to match the absorption peak of the vapor cell. In order to couple light into the ring resonators, the resonance frequency of the resonators should match the frequency of the light emitted by laser sources 210A and 210B. The output of the PDs 521 can be used in a servo (e.g., circuitry or a software function in the control system (not shown)) to adjust heaters 525A and 525B so that the resonant frequency of the frequency doublers 215 matches the frequency of the optical signals. Put differently, the frequency doublers 215 can be temperature sensitive, and the PDs 521 and the heaters 525 can compensate for temperature fluctuations.

In one embodiment, the PIC 505 and the PIC 510 include different materials for forming their respective optical components. For example, the PIC 505 can be SiN while the PIC 510 is LiNbO₃ (e.g., a second order non-linear material). The two PICs 505 and 510 can be aligned so that the output waveguides of the PIC 505 align with input waveguides in the PIC 510. For example, the two PICs 505 and 510 can be butt coupled using respective sides. In another embodiment, the two PICs could be disposed on top of each other (e.g., wafer bonded) and are optically coupled in the vertical direction.

As mentioned when discussing Figure 2B, all the components shown in Figure 5 can be in a single PIC. For example, the PIC could be a SiN wafer where transfer printing is used to add a layer of LiNbO₃ at locations of the PIC that include the optical components that use a second order non-linear material, e.g., the phase modulator 197, the amplitude modulator 415, and the frequency doublers 215, or the entire PIC could be formed using LiNbO₃.

Further, while the amplitude control 125B is in the PIC 510 and the amplitude control 125A is in the PIC 505, the amplitude control 125B can be implemented in the PIC 505 and conversely the amplitude control 125A could be implemented in the PIC 510.

The PICs 505 and 510 can be formed using SiN, aluminum nitride, tantalum pentoxide, LiNbO₃, and the like. In general, the PICs 505 and 510 can be formed from any two different materials that can implement the optical components described above.

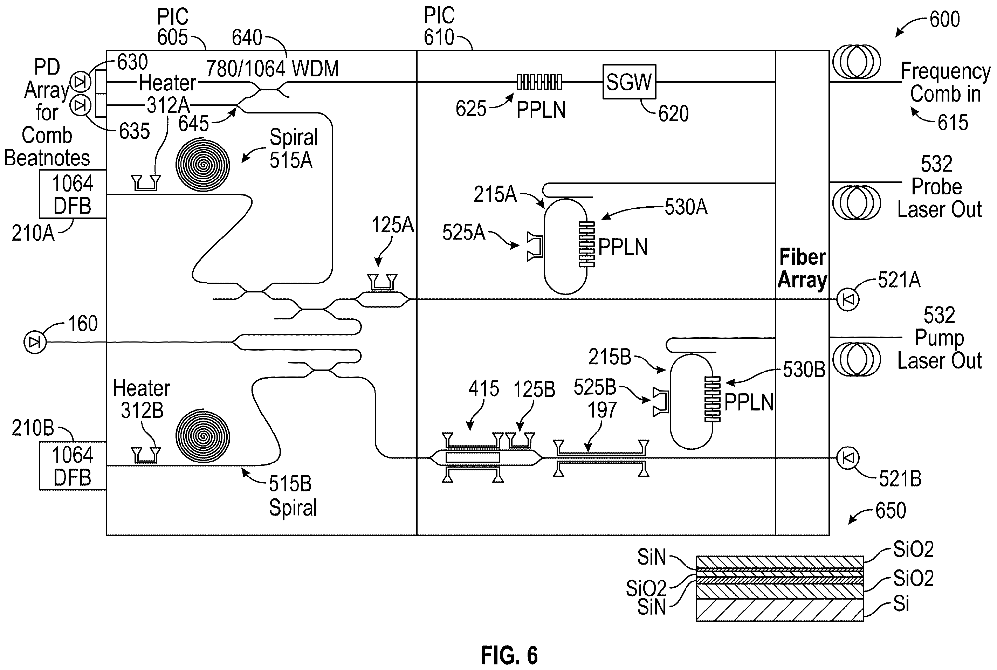

Figure 6 is a photonic system 600 that includes PIC 605 and PIC 610, which can be made from two different materials (e.g., SiN and LiNbO₃) or could be implemented using one PIC by that includes a second order non-linearity material, or by selective depositing a second order non-linearity material on portions of a SiN PIC that include the amplitude modulator 415, the phase modulator 197, and the frequency doublers 215.

Unlike the previous figures where the reference signal 180 is being transmitted off the chip to be used, e.g., to stabilize a frequency comb, here, a frequency comb 615 is being received by the PIC 610. In general, a frequency comb is stabilized by locking the frequency of the Carrier Envelope Offset (f_{CEO}) and the repetition rate (fᵣₑₚ) of the pulses or a tooth in the frequency comb. One stabilization strategy for f_{CEO} locking is self-referencing where a beatnote is generated between a frequency doubled lower frequency end of the comb spectrum with a high-frequency end, assuming the spectrum covers an optical octave. Such a broad spectrum can be achieved using supercontinuum generation. To do this, the PIC 610 includes a supercontinuum generation waveguide (SGW) 620. One non-limiting example of a two-segment SGW is described in U.S. Patent 11,953,804 which is incorporated herein by reference. There, a first segment of the SGW 620 is designed to spread the spectrum of the frequency comb so that a significant portion of the intensity of the frequency comb is at double the frequency of the original frequency comb. A second segment of the SGW is designed to spread the spectrum of the frequency comb so that a significant portion of the intensity of the frequency comb is at a frequency of a reference laser. For example, for a frequency comb that has a wavelength of 1560 nm and the reference laser (i.e., the laser source 210A) that has a wavelength of 1064 nm, the output of the SGW 620 produces a frequency comb that has significant intensity at 780 nm (frequency doubled), 1064 nm, and the original wavelength of 1560 nm.

This optical signal can then pass through a frequency doubler (implemented here as a PPLN 625) that doubles only the portion of the light in the frequency comb that is still at 1560 nm in order to generate another optical signal at 780 nm. A wavelength division multiplexor (WDM) 640 separates the 780nm from the 1064 light. The frequency doubled light generated by the PPLN 625 can then be detected by a PD 630 along with the 780 nm light generated by the first segment of the SGW to generate a first beatnote corresponding to the CEO. The light in the optical signal at 1064 nm can be combined with the reference laser (which is at the same wavelength) by a combiner 645 and detected by a photodiode 635 to generate a second beatnote These beatnotes can then be used in servo loops to adjust various actuators in the frequency comb in order to stabilize it to the laser source 210A (i.e., the reference laser). As shown above in Figs. 1A-2B, the laser source 210A (and laser source 105A) are locked to the spectroscopy signal 136 generated by transmitting the pump and probe signals through the vapor cell.

While the SGW 620 can be implemented using the two-segment SGW described in U.S. Patent 11,953,804, it is not limited to such. A one segment SGW 620 may be suitable in some embodiments.

While Figure 6 illustrates combining the reference laser generated by the laser source 210A with the frequency comb 615 after passing through the SGW 620 and frequency doubler (e.g., the PPLN 625), the reference laser can be combined with the frequency comb 615 before the frequency comb 615 passes through the SGW 620. However, this might make the arrangement more complicated since the SGW 620 and the PPLN 625 are implemented using the second order non-linear material of the PIC 610, while the components of the reference laser (e.g., the spiral 515 with the self-injection locks) may be more efficiently implemented in SiN. As such, one of the outputs of the laser source 210A would be routed through both the PIC 605 and the PIC 610 in order to combined with the frequency comb 615 before reaching the SGW 620. Put differently, the combiner 645 could be moved to a region upstream from the SGW 620. As a note, in this case the reference laser would also pass through the SGW 620, but it is unaffected by the SGW 620.

While Figure 6 illustrates using 1064 nm laser sources 210, a similar approach can be used using 520 nm laser sources, such as the system shown in Figure 4. However, it is easier to extend the frequency comb 615 from 1560 nm to 1064 nm, than to extend the comb to a 520 nm reference laser using the SGW 620. Regardless whether 1064 nm or 520 nm lasers are used, the photonic system 600 provides tight integration between clock and comb lasers and reduces the chance of excess phase noise and reduces the number of external, discrete components.

Figure 6 also illustrates a stack up 650 of the PIC 605 assuming it is a SiN platform. The stack up 650 includes two SiN layers where the lower SiN layer is thicker than the upper SiN layer. This is because a smaller thickness SiN layer (e.g., less than 100 nm in thickness) is desired for ultra-low loss narrow linewidth CW lasers generated by the laser sources 210. However, dispersion engineered SiN for self and optical referencing typically uses waveguides that have a thickness greater than 500 nm (which is provided by the lower SiN layer). The PIC 605 can include transition layers for moving optical signals between the lower and upper SiN waveguides.

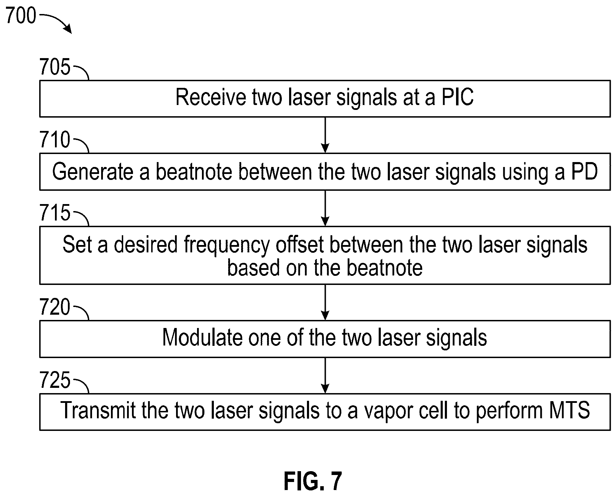

Figure 7 is a flowchart of a method 700 for performing MTS, according to one embodiment. At block 705, a PIC receives two laser signals from two laser sources. While many of the figures above illustrate laser sources that are, at least partially, separate from the PIC, they may include laser sources integrated onto the PIC.

At block 710, a PD on the PIC generates a beatnote between the two laser signals. In one embodiment, an optical combiner (e.g., a combiner implemented on a PIC, or a discrete component) interferometrically combines the two laser signals before they are received at the PD.

While it may be advantageous to dispose the PD on the PIC, it does not have to be. In other embodiments, the PIC may combine the two laser signals and transmit this combined optical signal to the PD. For example, the PD may be mounted on the top or side of the PIC.

At block 715, an offset servo (e.g., the offset servo 121 in Figure 1B) sets a desired frequency offset between the two laser signals based on the beatnote received from the PD. In one embodiment, the frequency offset may be 100-200 MHz. The offset servo can provide a control signal to at least one of the laser sources in order to maintain the desired frequency offset.

At block 720, the control system modulates the frequency or phase of one of the laser signals. This can be done by controlling a parameter of one of the laser sources (e.g., modulating the current or voltage) as shown in Figures 1B, 2A, and 3, or by using a phase modulator in the PIC as shown in Figures 1C, 2B, and 4-6. This modulation can be a dither or a sweep of the frequency.

At block 725, the PIC transmits the two laser signals to a vapor cell to perform MTS. In this example, one of the laser signals is a probe, which is unmodulated, while the other is the pump, which is modulated. Further, the pump and probe have the desired offset frequency.

Based on the interference of the pump and probe in the vapor cell, the vapor cell generates a spectroscopy signal (e.g., signal 136 in Figures 1B-2B) which can be used to lock one of the laser sources to an absorption peak of the vapor cell. For example, a MTS servo (e.g., the MTS servo 123 in Figures 1B-2B) can receive the spectroscopy signal and adjust the frequency of one of the laser sources (e.g., the laser source that generates the probe). This may change the frequency offset between the two laser sources, but this can be detected by the PD and the offset servo which can then adjust the other laser source (e.g., the laser source that generates the pump) to maintain the desired frequency offset.

The preceding description is provided to enable any person skilled in the art to practice the various embodiments described herein. The examples discussed herein are not limiting of the scope, applicability, or embodiments set forth in the claims. Various modifications to these embodiments will be readily apparent to those skilled in the art, and the generic principles defined herein may be applied to other embodiments. For example, changes may be made in the function and arrangement of elements discussed without departing from the scope of the disclosure. Various examples may omit, substitute, or add various procedures or components as appropriate. For instance, the methods described may be performed in an order different from that described, and various steps may be added, omitted, or combined. Also, features described with respect to some examples may be combined in some other examples. For example, an apparatus may be implemented or a method may be practiced using any number of the aspects set forth herein. In addition, the scope of the disclosure is intended to cover such an apparatus or method that is practiced using other structure, functionality, or structure and functionality in addition to, or other than, the various aspects of the disclosure set forth herein. It should be understood that any aspect of the disclosure disclosed herein may be embodied by one or more elements of a claim.

As used herein, the word "exemplary" means "serving as an example, instance, or illustration." Any aspect described herein as "exemplary" is not necessarily to be construed as preferred or advantageous over other aspects.

As used herein, a phrase referring to "at least one of" a list of items refers to any combination of those items, including single members. As an example, "at least one of: a, b, or c" is intended to cover a, b, c, a-b, a-c, b-c, and a-b-c, as well as any combination with multiples of the same element (e.g., a-a, a-a-a, a-a-b, a-a-c, a-b-b, a-c-c, b-b, b-b-b, b-b-c, c-c, and c-c-c or any other ordering of a, b, and c).

As used herein, the term "determining" encompasses a wide variety of actions. For example, "determining" may include calculating, computing, processing, deriving, investigating, looking up (e.g., looking up in a table, a database or another data structure), ascertaining and the like. Also, "determining" may include receiving (e.g., receiving information), accessing (e.g., accessing data in a memory) and the like. Also, "determining" may include resolving, selecting, choosing, establishing and the like.

The methods disclosed herein comprise one or more steps or actions for achieving the methods. The method steps and/or actions may be interchanged with one another without departing from the scope of the claims. In other words, unless a specific order of steps or actions is specified, the order and/or use of specific steps and/or actions may be modified without departing from the scope of the claims. Further, the various operations of methods described above may be performed by any suitable means capable of performing the corresponding functions. The means may include various hardware and/or software component(s) and/or module(s), including, but not limited to a circuit, an application specific integrated circuit (ASIC), or processor. Generally, where there are operations illustrated in figures, those operations may have corresponding counterpart means-plus-function components with similar numbering.

As will be appreciated by one skilled in the art, the embodiments disclosed herein may be embodied as a system, method, or computer program product. Accordingly, embodiments may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, embodiments may take the form of a computer program product embodied in one or more computer readable medium(s) having computer readable program code embodied thereon.

Program code embodied on a computer readable medium may be transmitted using any appropriate medium, including but not limited to wireless, wireline, optical fiber cable, RF, etc., or any suitable combination of the foregoing.

Computer program code for carrying out operations for embodiments of the present disclosure may be written in any combination of one or more programming languages, including an object oriented programming language such as Java, Smalltalk, C++ or the like and conventional procedural programming languages, such as the "C" programming language or similar programming languages. The program code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present disclosure are described herein with reference to flowchart illustrations and/or block diagrams of methods, apparatuses (systems), and computer program products according to embodiments presented in this disclosure. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the block(s) of the flowchart illustrations and/or block diagrams.

These computer program instructions may also be stored in a computer readable medium that can direct a computer, other programmable data processing apparatus, or other device to function in a particular manner, such that the instructions stored in the computer readable medium produce an article of manufacture including instructions which implement the function/act specified in the block(s) of the flowchart illustrations and/or block diagrams.

The computer program instructions may also be loaded onto a computer, other programmable data processing apparatus, or other device to cause a series of operational steps to be performed on the computer, other programmable apparatus or other device to produce a computer implemented process such that the instructions which execute on the computer, other programmable data processing apparatus, or other device provide processes for implementing the functions/acts specified in the block(s) of the flowchart illustrations and/or block diagrams.

The flowchart illustrations and block diagrams in the Figures illustrate the architecture, functionality, and operation of possible implementations of systems, methods, and computer program products according to various embodiments. In this regard, each block in the flowchart illustrations or block diagrams may represent a module, segment, or portion of code, which comprises one or more executable instructions for implementing the specified logical function(s). It should also be noted that, in some alternative implementations, the functions noted in the block may occur out of the order noted in the Figures. For example, two blocks shown in succession may, in fact, be executed substantially concurrently, or the blocks may sometimes be executed in the reverse order, depending upon the functionality involved. It will also be noted that each block of the block diagrams and/or flowchart illustrations, and combinations of blocks in the block diagrams and/or flowchart illustrations, can be implemented by special purpose hardware-based systems that perform the specified functions or acts, or combinations of special purpose hardware and computer instructions.

The following claims are not intended to be limited to the embodiments shown herein, but are to be accorded the full scope consistent with the language of the claims. Within a claim, reference to an element in the singular is not intended to mean "one and only one" unless specifically so stated, but rather "one or more." Unless specifically stated otherwise, the term "some" refers to one or more. No claim element is to be construed under the provisions of 35 U.S.C. §112(f) unless the element is expressly recited using the phrase "means for" or, in the case of a method claim, the element is recited using the phrase "step for." All structural and functional equivalents to the elements of the various aspects described throughout this disclosure that are known or later come to be known to those of ordinary skill in the art are expressly incorporated herein by reference and are intended to be encompassed by the claims. Moreover, nothing disclosed herein is intended to be dedicated to the public regardless of whether such disclosure is explicitly recited in the claims.
Further embodiments
1. A photonic system, comprising:
   a first laser source configured to generate a pump optical signal for modulation transfer spectroscopy (MTS);
   a second laser source configured to generate a probe optical signal for MTS;
   an optical combiner configured to optically combine a portion of the pump and probe optical signals to generate a combined optical signal;
   a photodiode configured to receive the combined optical signal and output a beatnote; and
   a control system configured to, based on receiving the beatnote, adjust a parameter of at least one of the first or second laser sources to set a desired frequency offset between the pump and probe optical signals.
2. The photonic system of embodiment 1, further comprising:
   a photonic integrated circuit (PIC) configured to receive the pump and probe optical signals, the PIC comprising:
   the combiner that optically combines a portion of the pump and probe optical signals; and
   amplitude controls configured to adjust amplitudes of the pump and probe optical signals.
3. The photonic system of embodiment 2, further comprising:
   a phase modulator disposed on the PIC, or disposed on a second PIC that is optically coupled to the PIC, wherein the phase modulator is configured to receive a portion of the pump optical signal and modulate the pump optical signal for performing MTS.
4. The photonic system of embodiment 3, wherein the control system is configured to control the phase modulator to generate spectroscopy signals derived from transmitting the pump and probe optical signals through a vapor cell.
5. The photonic system of embodiment 3, wherein the phase modulator is disposed on the second PIC, wherein the second PIC is formed from a second order non-linearity material.
6. The photonic system of embodiment 5, wherein the second PIC comprises frequency doublers configured to change the frequency of the pump and probe optical signals.
7. The photonic system of embodiment 6, wherein the second PIC comprises a Mach-Zehnder interferometer (MZI) structure configured to receive the pump optical signal, wherein a first part of the MZI structure implements a push-pull amplitude modulator to cancel out residual amplitude modulation while a second part of the MZI structure implements one of the amplitude controls.
8. The photonic system of embodiment 3, wherein the phase modulator is disposed on the PIC, wherein the PIC includes at least a first layer that is a second order non-linearity material, wherein at least one of the amplitude controls is formed in a second layer of the PIC that does not include the second order non-linearity material.
9. The photonic system of embodiment 8, wherein the PIC comprises frequency doublers implemented using the first layer, wherein the frequency doublers are configured to change a frequency of the pump and probe optical signals.
10. The photonic system of embodiment 2, wherein the PIC comprises resonator or filter structures to force single longitudinal mode operation and narrow a linewidth of the pump and probe optical signals before reaching the amplitude controls and the photodiode.
11. The photonic system of embodiment 2, wherein the PIC is configured to receive a frequency comb and combine the frequency comb with a portion of the probe optical signal.
12. The photonic system of embodiment 11, wherein the PIC comprises:
   a supercontinuum generation waveguide (SGW) configured to spread a spectrum of the frequency comb.
13. The photonic system of embodiment 12, further comprising:
   a second PIC comprising a second order non-linearity material, the second order non-linearity material comprising:
   a frequency doubler configured to change a frequency of the frequency comb after passing through the SGW.
14. The photonic system of embodiment 12, further comprising:
   a second PIC comprising a second order non-linearity material, wherein the second PIC is aligned with the PIC, wherein the second PIC comprises:
   a SGW configured to spread a spectrum of the frequency comb; and
   a frequency doubler formed using the second order non-linearity material, wherein the frequency doubler is configured to change the frequency of the frequency comb after passing through the SGW, wherein the frequency comb first passes through the second PIC before being optically combined with the portion of the probe optical signal in the PIC.
15. The photonic system of embodiment 2, wherein the amplitude controls comprise Mach-Zehnder interferometers (MZI) comprising thermo-optic heaters as phase shifters in one arm.
16. The photonic system of embodiment 1, wherein the control system is configured to modulate the first laser source in order to generate a modulated pump optical signal for performing MTS.
17. The photonic system of embodiment 1, wherein the control system is further configured to use a spectroscopy signal resulting from passing the pump and probe optical signals through a vapor cell to lock the probe and pump optical signals.
18. A PIC, comprising:
   waveguides configured to:
   direct a first portion of a pump optical signal to a vapor cell for MTS;
   combine a second portion of the pump optical signal with a first portion of a probe optical signal to generate a combined optical signal;
   direct the combined optical signal to a photodiode configured to output a beatnote for maintaining a frequency offset between the pump and probe optical signals; and
   direct a second portion of the probe optical signal to the vapor cell for MTS.
19. The PIC of embodiment 18, further comprising:
   a first amplitude control configured to receive the pump optical signal before being directed to the vapor cell; and
   a second amplitude control configured to receive the probe optical signal before being directed to the vapor cell;
   wherein the first and second amplitude controls comprise Mach-Zehnder interferometers (MZI) comprising thermo-optic heaters as phase shifters in one arm.
20. The PIC of embodiment 18, further comprising:
   a phase modulator implemented using a layer of second order non-linearity material, wherein the phase modulator is configured to receive a portion of the pump optical signal and modulate the pump optical signal for performing MTS.
21. The PIC of embodiment 18, further comprising:
   frequency doublers implemented using a second order non-linearity material in the PIC, wherein the frequency doublers are configuredto adjust a frequency of the probe and pump optical signals.
22. The PIC of embodiment 18, wherein the waveguides are configured to receive a frequency comb and combine the frequency comb with a third portion of the probe optical signal.
23. The PIC of embodiment 18, further comprising:
   a phase modulator, wherein the PIC is made out of a second order non-linearity material such that the waveguides and the phase modulator are formed using the second order non-linearity material.
24. A photonic system, comprising:
   a first laser source configured to generate a pump optical signal for modulation transfer spectroscopy (MTS);
   a second laser source configured to generate a probe optical signal for MTS; and
   a PIC according to any one of embodiments 18 to 23.
25. A method, comprising:
   receiving two laser signals from two separate laser sources;
   generating a beatnote between the two laser signals using a photodiode;
   setting a desired frequency offset between the two laser signals based on the beatnote;
   modulating one of the two laser signals to generate a pump optical signal, wherein the other of the two laser signals is unmodulated to generate a probe optical signal; and
   transmitting the pump optical signal and the probe optical signal to a vapor cell to perform modulation transfer spectroscopy (MTS).

## Claims

1. A photonic system, comprising:
a first laser source configured to generate a pump optical signal for modulation transfer spectroscopy (MTS);
a second laser source configured to generate a probe optical signal for MTS;
an optical combiner configured to optically combine a portion of the pump and probe optical signals to generate a combined optical signal;
a photodiode configured to receive the combined optical signal and output a beatnote; and
a control system configured to, based on receiving the beatnote, adjust a parameter of at least one of the first or second laser sources to set a desired frequency offset between the pump and probe optical signals.

2. The photonic system of claim 1, further comprising:
a photonic integrated circuit (PIC) configured to receive the pump and probe optical signals, the PIC comprising:
the combiner that optically combines a portion of the pump and probe optical signals; and
amplitude controls configured to adjust amplitudes of the pump and probe optical signals.

3. The photonic system of claim 2, further comprising:
a phase modulator disposed on the PIC, or disposed on a second PIC that is optically coupled to the PIC, wherein the phase modulator is configured to receive a portion of the pump optical signal and modulate the pump optical signal for performing MTS.

4. The photonic system of claim 3, wherein the control system is configured to control the phase modulator to generate spectroscopy signals derived from transmitting the pump and probe optical signals through a vapor cell.

5. The photonic system of claim 3, wherein the phase modulator is disposed on the second PIC, wherein the second PIC is formed from a second order non-linearity material.

6. The photonic system of claim 5, wherein the second PIC comprises frequency doublers configured to change the frequency of the pump and probe optical signals; especially
wherein the second PIC comprises a Mach-Zehnder interferometer (MZI) structure configured to receive the pump optical signal, wherein a first part of the MZI structure implements a push-pull amplitude modulator to cancel out residual amplitude modulation while a second part of the MZI structure implements one of the amplitude controls.

7. The photonic system of claim 3, wherein the phase modulator is disposed on the PIC, wherein the PIC includes at least a first layer that is a second order non-linearity material, wherein at least one of the amplitude controls is formed in a second layer of the PIC that does not include the second order non-linearity material; especially
wherein the PIC comprises frequency doublers implemented using the first layer, wherein the frequency doublers are configured to change a frequency of the pump and probe optical signals.

8. The photonic system of claim 2, wherein the PIC comprises resonator or filter structures to force single longitudinal mode operation and narrow a linewidth of the pump and probe optical signals before reaching the amplitude controls and the photodiode.

9. The photonic system of claim 2, wherein the PIC is configured to receive a frequency comb and combine the frequency comb with a portion of the probe optical signal.

10. The photonic system of claim 9, wherein the PIC comprises:
a supercontinuum generation waveguide (SGW) configured to spread a spectrum of the frequency comb.

11. The photonic system of claim 10, further comprising:
a second PIC comprising a second order non-linearity material, the second order non-linearity material comprising a frequency doubler configured to change a frequency of the frequency comb after passing through the SGW

12. The photonic system of claim 10, further comprising:
a second PIC comprising a second order non-linearity material, wherein the second PIC is aligned with the PIC, wherein the second PIC comprises:
a SGW configured to spread a spectrum of the frequency comb; and
a frequency doubler formed using the second order non-linearity material, wherein the frequency doubler is configured to change the frequency of the frequency comb after passing through the SGW, wherein the frequency comb first passes through the second PIC before being optically combined with the portion of the probe optical signal in the PIC.

13. The photonic system of claim 2, wherein the amplitude controls comprise Mach-Zehnder interferometers (MZI) comprising thermo-optic heaters as phase shifters in one arm.

14. The photonic system of claim 1, wherein the control system is configured to modulate the first laser source in order to generate a modulated pump optical signal for performing MTS; and/or
wherein the control system is further configured to use a spectroscopy signal resulting from passing the pump and probe optical signals through a vapor cell to lock the probe and pump optical signals.

15. A method, comprising:
receiving two laser signals from two separate laser sources;
generating a beatnote between the two laser signals using a photodiode;
setting a desired frequency offset between the two laser signals based on the beatnote;
modulating one of the two laser signals to generate a pump optical signal, wherein the other of the two laser signals is unmodulated to generate a probe optical signal; and
transmitting the pump optical signal and the probe optical signal to a vapor cell to perform modulation transfer spectroscopy (MTS).
